Europäisches Patentamt

(19) European Patent Office

Office européen des brevets

(11) Numéro de publication : **0 197 832**
**B1**

(12) **FASCICULE DE BREVET EUROPÉEN**

(45) Date de publication du fascicule du brevet :
**09.08.89**

(21) Numéro de dépôt : **86400614.3**

(22) Date de dépôt : **24.03.86**

(51) Int. Cl.⁴ : **H 01 L 31/02**, H 01 L 31/18

(54) Procédé d'allègement de cellules solaires et cellules ainsi obtenues.

(30) Priorité : **26.03.85 FR 8504464**

(43) Date de publication de la demande :
**15.10.86 Bulletin 86/42**

(45) Mention de la délivrance du brevet :
**09.08.89 Bulletin 89/32**

(84) Etats contractants désignés :
**AT BE CH DE FR GB IT LI LU NL SE**

(56) Documents cités :
EP–A– 0 033 380
EP–A– 0 116 791
DE–A– 3 114 309
DE–A– 3 446 885
FR–A– 2 437 699
FR–A– 2 481 519
GB–A– 1 513 141
US–A– 4 348 254
US–A– 4 451 969
US–A– 4 498 225

(73) Titulaire : **CENTRE NATIONAL D'ETUDES SPATIALES**
**2, Place Maurice Quentin**
**F-75001 Paris (FR)**

(72) Inventeur : **Cuquel, Alain Patrice Gilles**
**30 Impasse Destarac**
**F-31400 Toulouse (FR)**

(74) Mandataire : **de Boisse, Louis Arnaud et al**
**CABINET de BOISSE 37, Avenue Franklin D. Roosevelt**
**F-75008 Paris (FR)**

## Description

La présente invention concerne un procédé d'allègement de cellules solaires (appelées aussi photopiles ou cellules photovoltaïques) par amincissement sélectif du substrat, ainsi que les cellules solaires allégées ainsi produites.

La fabrication des cellules solaires actuelles, telles que les cellules au silicium ou à l'arséniure de gallium, est basée sur la création d'une homojonction ou d'une hétérojonction par des techniques de diffusion ou d'épitaxie sur un substrat de base. Ces substrats ont une épaisseur d'environ 150 à 400 μm qui est très supérieure pour certains matériaux à l'épaisseur correspondant à l'absorption du spectre solaire, qui est typiquement d'une à quelques dizaine(s) de micromètres. Par conséquent une grande partie de l'épaisseur du substrat de base est inutile dans le processus de création de courant électrique par effet photovoltaïque dans ce type de matériaux.

Comme un des domaines d'application des cellules solaires se trouve dans les satellites et autres véhicules spatiaux, on a cherché depuis longtemps à réduire la masse des cellules solaires en amaincissant les substrats des cellules.

Il existe actuellement deux principaux types de procédés d'amincissement des substrats, à savoir un procédé par polissage mécanique, mécano-chimique ou chimique, et un procédé dénommé CLEFT développé par le M.I.T. aux Etats-Unis, pour la fabrication de cellules solaires à l'arséniure de gallium.

Ces deux procédés permettent effectivement de réduire l'épaisseur du substrat après fabrication de la cellule solaire, mais présentent le défaut de réaliser un amincissement uniforme du substrat, ce qui rend critique le procédé de fabrication.

La présente invention vise à remédier à ce défaut en fournissant un procédé d'allègement d'une cellule solaire par amincissement sélectif du substrat, qui permet de conserver une bonne tenue mécanique à la cellule, de réduire le nombre d'opérations de fabrication et leur difficulté d'exécution.

Plus précisément, l'invention concerne un procédé d'allègement d'une cellule solaire pouvant être mis en œuvre au cours du processus de fabrication de cette cellule, caractérisé en ce qu'il comprend les étapes suivantes :

(a) application sur la face arrière nue du substrat de base de la cellule d'une couche d'une composition de réserve photosensible, le substrat ayant une épaisseur d'au moins 150 μm,

(b) exposition sélective de la face arrière revêtue du substrat obtenue dans l'étape (a) de façon à former un motif de composition de réserve de configuration appropriée adhérant à cette face arrière, ledit motif comprenant une pluralité de zones discrètes non durcies séparées les unes des autres par des zones durcies, le rapport de la surface des zones non durcies à la surface des zones durcies étant d'au moins 1 : 1,

(c) éliminer les zones non durcies de la composition de réserve de façon à mettre à nu le substrat dans ces zones,

(d) attaquer chimiquement et isotropiquement les zones dénudées du substrat jusqu'à ce que l'épaisseur du substrat dans ces zones soit réduite sensiblement uniformément à une valeur comprise entre 10 et 100 μm, les zones ainsi amincies étant séparées les unes des autres par des nervures ayant l'épaisseur initiale du substrat, et

(e) élimination des zones durcies de la composition de réserve.

Le motif de composition de réserve photosensible durcie que l'on forme sur le substrat dans l'étape (b) peut avoir diverses configurations. La configuration dudit motif devra être choisie pour atteindre un compromis optimum entre le gain en masse et la conservation d'une bonne tenue mécanique. A titre indicatif on peut utiliser des motifs géométriques à mailles répétées, par exemple à mailles carrées ou rectangulaires (configuration en forme de grilles), pentagonales, hexagonales (configuration en nid d'abeilles, circulaires, etc..., mais d'autres types de motifs pourraient être conçus, ainsi que cela sera évident pour l'homme de l'art.

Le gain en masse, pour être significatif, doit être d'au moins 30 %, de préférence d'au moins 50 % et peut même dépasser 60 %. Le gain en masse est le rapport

$$\frac{\text{masse initiale du substrat} - \text{masse finale du substrat}}{\text{masse initiale du substrat}}$$

Pour conserver au substrat allégé une bonne tenue mécanique, il faut que les nervures séparant les zones amincies forment un réseau suffisamment dense et soient suffisamment épaisses pour présenter une résistance mécanique correcte. Il faut veiller en particulier à ce que les zones durcies du motif de réserve qui définissent les nervures, soient suffisamment larges pour que le phénomène de sous-gravure qui ·tend normalement à se produire lorsqu'on procède à l'attaque chimique (d) ne « mine » pas complètement les nervures par en dessous. L'ampleur de ce phénomène de sous-gravure dépend de la profondeur d'attaque. Elle devient sensible pour une profondeur d'attaque supérieure à 100 μm et est plus importante pour une profondeur d'attaque de 300 μm, par exemple, que de 100 μm. Elle varie aussi beaucoup en fonction des conditions d'agitation du bain d'attaque chimique. Il est donc assez difficile de définir une largeur minimale pour les zones durcies du motif de réserve. A titre indicatif, il est recommandé de prévoir des zones durcies d'une largeur minimale au moins égale à la profondeur d'attaque à réaliser, voire de 1,5 ou même 2 fois cette profondeur.

Il faut aussi que le réseau de nervures soit assez dense, c'est-à-dire que les zones amincies n'aient pas une surface unitaire trop importante. Bien qu'il n'y ait pas de valeur critique pour cette surface unitaire, il n'est pas souhaitable qu'elle excède 2 cm², de préférence 1 cm². Elle sera habituellement comprise entre 0,25 et 1 cm² environ.

Comme composition de réserve photosensible, on peut utiliser toutes compositions de réserve de type positif ou négatif, sensible à un rayonnement électromagnétique, par exemple la lumière visible ou ultra-violette. L'exposition sélective peut se faire à travers un élément transparent portant un motif semblable ou complémentaire (selon le type de composition de réserve utilisé) de celui que l'on veut former dans l'étape (b), ou encore en apposant un masque de configuration approprié sur le substrat. De nombreuses compositions de réserve photosensibles sont décrites dans la littérature des brevets et sont disponibles dans le commerce en provenance de divers fabricants, leur usage étant très répandu dans le domaine de la fabrication de circuits imprimés. Des exemples de telles compositions sont les produits vendus sous les désignations commerciales AZ 135OJ et AZ 135OH par la Société américaine SHIPLEY.

L'invention concerne aussi les cellules solaires allégées obtenues par le procédé de l'invention.

La description qui vasuivre faite en se référant aux dessins annexés fera bien comprendre la présente invention. Sur ces dessins :

La figure 1 est une vue schématique en coupe d'une cellule solaire à l'arséniure de gallium avant métallisation de la face arrière du substrat ;

Les figures 2 à 5 sont des vues schématiques en coupe (figures 2, 4 et 5) ou vue de dessous (figure 3) illustrant diverses étapes du procédé de l'invention ; et

Les figures 6A et 6B sont des vues schématiques en coupe montrant respectivement, de façon comparative, une cellule classique non allégée et une cellule allégée selon l'invention.

La description détaillée du procédé de l'invention va être faite ci-dessous à propos d'une photopile à l'arséniure de gallium, mais il va de soi que l'invention n'est pas limitée à ce genre de photopiles et peut être appliquée à des cellules solaires de tous types.

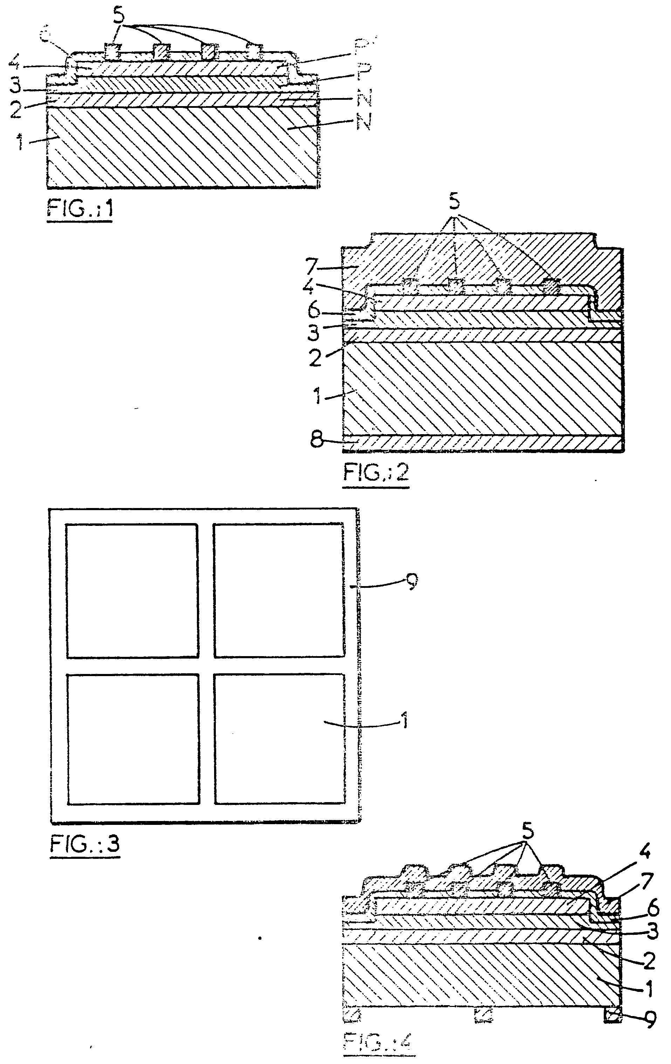

La figure 1 montre une photopile à l'arséniure de gallium typique avant métallisation de la face arrière du substrat. Cette photopile comprend typiquement un substrat 1 en arséniure de gallium de type N, une couche active 2 de type N, une couche avant 3 de type P constituant avec la couche 2 une jonction P N, une couche dite « fenêtre » 4 en GaAlAs de type P$^+$ qui crée un champ électrique repoussant les photoporteurs vers la jonction, une métallisation en forme de « peigne » 5 et une couche anti-reflet 6 constituée d'un oxyde métallique tel que $Ta_2O_5$, $SiO_2$ etc...

Les épaisseurs des différentes couches semi-conductrices sont typiquement de 150 à 400 μm pour le substrat 1, d'environ 5 à 10 μm pour la couche 2, de 0,3 à 5 μm pour la couche 3 et de 0,1 à 1 μm pour la couche 4. La majeure partie de la masse de la photopile est donc attribuable au substrat 1.

Selon le procédé de l'invention, on commence (figure 2) par appliquer sur les faces exposées du substrat 1 (d'une épaisseur de 220 μm), d'une part, et de la métallisation 5 et de la couche 6, d'autre part, une composition de réserve photosensible de type positif, vendue sous la désignation commerciale AZ 135OJ par la Société SHIPLEY. Cette composition durcit en température en formant des couches protectrices 7 et 8 sur la métallisation 5 et la couche 6, d'une part, et sur le substrat 1, d'autre part. Ces couches protectrices ont une bonne résistance aux agents chimiques et une bonne adhérence sur l'arséniure de gallium.

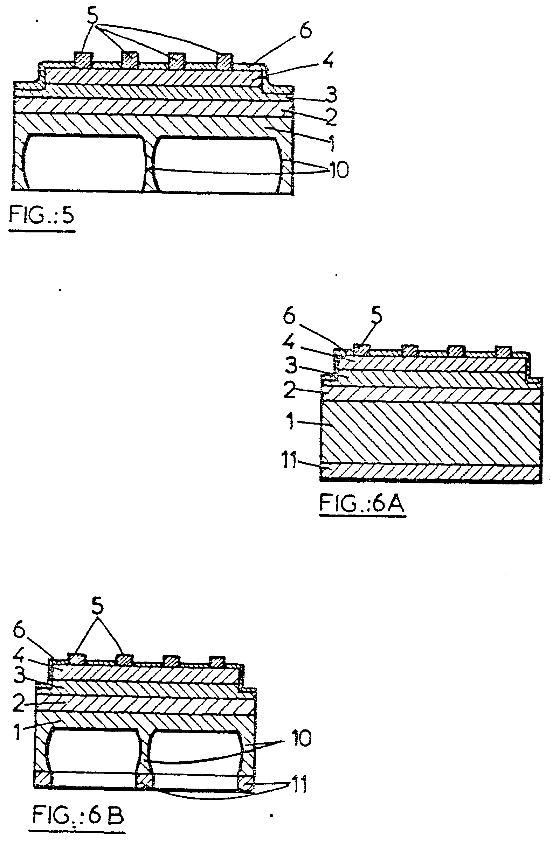

Ensuite, on expose la couche 8 appliquée sur le substrat pendant environ 5 secondes à un rayonnement ultraviolet provenant d'une source constituée par une lampe à vapeur de mercure et d'un système optique permettant un éclairement en faisceau parallèle du substrat, après avoir apposé sur cette couche un masque en forme de quadrillage. Cette exposition a pour effet de dégrader la couche 8 dans les zones exposées et de les rendre solubles dans un bain de lavage ou révélateur. Après l'exposition, on lave ou développe la couche exposée dans un bain de lavage (révélateur) constitué d'une solution aqueuse basique (produit AZ 50 ou AZ 351 vendu par la Société SHIPLEY) pendant 1 minute environ pour éliminer les parties exposées de la couche. On obtient ainsi sur le substrat un motif de réserve en forme de quadrillage 9 comme illustré par les figures 3 et 4. La surface de chaque carré unitaire du quadrillage est d'environ 1 cm². La largeur de chaque ligne du quadrillage est d'environ 200 μm.

Ensuite, on procède à l'attaque chimique du substrat 1 dans les zones laissées nues par le quadrillage 9 en mettant en contact ces zones avec une composition d'attaque constituée d'eau désionisée, d'eau oxygénée à 30 volumes et d'acide sulfurique concentré dans un rapport en volume de 3/1/1. La vitesse d'attaque est de l'ordre de 10 μm/mn. On poursuit l'attaque jusqu'à ce que l'épaisseur résiduelle du substrat dans les zones attaquées soit de 50 μm environ. Il est à noter que, dès que la profondeur d'attaque atteint ou dépasse 100 μm environ, il se produit un certain effet de sous-gravure non négligeable. Ceci fait qu'il faut prévoir pour les lignes du quadrillage (ou pour les éléments constitutifs de tout autre motif protecteur choisi) une largeur suffisante pour éviter que les cavités générées par l'attaque ne se rejoignent pas en dessous le motif protecteur ou n'affaiblissent exagérément les nervures 10 qui subsistent après l'attaque. Une fois l'attaque terminée, on lave la cellule dans de l'eau désionisée, puis on la sèche, par exemple sous un jet d'azote. La composition de réserve durcie qui subsiste sur la cellule est

3

alors éliminée, par exemple dans un bain de solvant approprié, tel que l'acétone. On obtient ainsi la cellule représentée sur la figure 5.

La fabrication de la cellule peut alors être achevée en effectuant une métallisation de la face arrière des nervures 10. Cette métallisation 11 peut être réalisée en procédant d'abord à un mince dépôt de métal par évaporation, puis en épaississant la couche mince de métal résultante par voie électrochimique, de manière connue.

Les figures 6A et 6B illustrent comparativement une cellule solaire conventionnelle (figure 61) et une cellule allégée selon l'invention (figure 6B). Grâce à l'invention, on peut obtenir un gain de masse de 50 % et plus. Il est à noter que l'invention permet également de réduire la masse de métallisation nécessaire.

Bien que l'invention ait été décrite plus particulièrement à propos d'une cellule solaire à l'arséniure de gallium, elle pourrait être mise en œuvre tout aussi bien avec d'autres types de cellules solaires, par exemple les cellules au silicium, comme cela sera évident pour l'homme de l'art.

Egalement, la mise en œuvre du procédé de l'invention pourrait s'insérer dans le processus de fabrication de la cellule à un moment autre que celui précédant la métallisation de la face arrière du substrat, comme cela sera évident pour l'homme de l'art.

Il va de soi que le mode de réalisation décrit n'est qu'un exemple et qu'on pourrait le modifier, notamment par substitution d'équivalents techniques, sans sortir pour cela du cadre de l'invention.

## Revendications

1. Procédé d'allègement d'une cellule solaire pouvant être mis en œuvre au cours du processus de fabrication de cette cellule, caractérisé en ce qu'il comprend les étapes suivantes :

(a) application sur la face arrière nue du substrat de base (1) de la cellule d'une couche d'une composition de réserve photosensible, le substrat ayant une épaisseur d'au moins 150 $\mu$m,

(b) exposition sélective de la face arrière revêtue du substrat obtenue dans l'étape (a) de façon à former un motif (9) de composition de réserve de configuration appropriée adhérant à cette face arrière, ledit motif comprenant une pluralité de zones discrètes non durcies séparées les unes des autres par des zones durcies, le rapport de la surface des zones non durcies à la surface des zones durcies étant d'au moins 1 : 1,

(c) éliminer les zones non durcies de la composition de réserve de façon à mettre à nu le substrat dans ces zones,

(d) attaquer chimiquement et isotropiquement les zones dénudées du substrat jusqu'à ce que l'épaisseur du substrat dans ces zones soit réduite sensiblement uniformément à une valeur comprise entre 10 et 100 $\mu$m, les zones ainsi amincies étant séparées les unes des autres par des nervures ayant l'épaisseur initiale du substrat, et

(e) élimination des zones durcies de la composition de réserve.

2. Procédé selon la revendication 1, caractérisé en ce que le gain de masse est d'au moins 30 %.

3. Procédé selon la revendication 2, caractérisé en ce que le gain de masse est d'au moins 50 %.

4. Procédé selon la revendication 1, caractérisé en ce que la largeur des zones durcies est au moins égale à la profondeur d'attaque chimique à réaliser.

5. Procédé selon la revendication 4, caractérisé en ce que la largeur des zones durcies est au moins égale à 1,5 fois la profondeur d'attaque chimique à réaliser.

6. Procédé selon la revendication 1, caractérisé en ce que la surface unitaire des zones non durcies est comprise entre 0,25 et 1 cm². 

7. Cellule solaire allégée produite par le procédé de la revendication 1, dont le substrat comporte des zones amincies d'épaisseur réduite uniformément jusqu'à des valeurs comprises entre 10 et 100 $\mu$m, les zones amincies étant séparées les unes des autres par des nervures du substrat.

## Claims

1. Process for lightening a solar cell which can be implemented during the process of manufacturing the cell, characterized in that it consists of the following stages :

(a) application of a layer of a photo resist composition on the bare rear face of the base substrate of the cell, the substrate having a thickness of at least 150 $\mu$m,

(b) selective exposure of the coated rear face of the substrate obtained in stage (a) so as to produce a resist composition pattern (9) of appropriate configuration adhering to this rear face, said pattern comprising a multitude of discrete unhardened regions separated from one another by hardened regions, the ratio of the area of the unhardened regions to the area of the hardened regions being at least 1 : 1,

(c) removing the unhardened regions of the resist composition so as to bare the substrate in these regions,

(d) etching of the bared regions of the substrate chemically and isotropically until the thickness of the substrate in these regions is reduced substantially uniformly to a value of between 10 and 100 $\mu$m, the

regions thus thinned being separated from one another by ribs which have the initial thickness of the substrate, and

(e) removal of the hardened regions of the resist composition.

2. Process as claimed in claim 1, wherein the mass gain is at least 30 %.

3. Process as claimed in claim 2, wherein the mass gain is at least 50 %.

4. Process as claimed in claim 1, wherein the width of the hardened regions is at least equal to the depth of chemical etching to be carried out.

5. Process as claimed in claim 4, wherein the width of the hardened zones is at least equal to 1.5 times the depth of chemical etching to be carried out.

6. Process as claimed in claim 1, wherein the unit area of the unhardened regions is between 0.25 and 1 cm$^2$.

7. Lightened solar cell produced by the process of claim 1, the substrate of which comprises thinned regions of thickness uniformly reduced to values comprised between 10 and 100 $\mu$m, the thinned regions being separated from one another by substrate ribs.


## Patentansprüche

1. Verfahren zum Erleichtern einer Solarzelle, welches während der Herstellung der Zelle angewandt wird und durch die folgenden Schritte gekennzeichnet ist :

(a) Aufbringung einer, aus einer strahlungsempfindlichen Masse bestehenden Deckschicht auf die blanke Rückseite des Basissubstrats der Zelle, wobei die Dicke des Substrates wenigtens 150 $\mu$m beträgt ;

(b) selektive Belichtung der beschichteten, gemäß dem Verfahrensschritt (a) erhaltenen Rückseite des Substrates zwecks Herstellung eines, an dieser Rückseite befindlichen, aus der Deckschicht geformten, eine passende Gestaltung aufweisenden Bildes, wobei das Bild eine Vielzahl einzelner nicht gehärteter Zonen aufweist, die voneinander durch gehärteter Zonen getrennt sind und wobei das Verhältnis der Oberflächen der nicht gehärteten Zonen zu denjenigen der gehärteten Zonen wenigstens 1 : 1 beträgt.

(c) Eliminierung der nicht gehärteten Zonen der die Deckschicht bildenden Masse, so daß in diesen Zonen das Substrat freigelegt wird ;

(d) isotropes chemisches Abtragen der freigelegten Zonen des Substrates, bis dessen Dicke in diesen Zonen wesentlich verringert worden ist, und zwar gleichförmig bis zu einem Wert zwischen 10 $\mu$m und 100 $\mu$m, wobei die auf diese Weise verdünnten Zonen voneinander durch solche Rippen getrennt sind, die die anfängliche Dicke des Substrats aufweisen und

(e) Eliminierung der gehärteten Zonen der die Deckschicht bildenden Masse.

2. Verfahren nach Anspruch 1, dadurch gekennzeichnet, daß der Gewinn an Masse wenigstens 30 % beträgt.

3. Verfahren nach Anspruch 2, dadurch gekennzeichnet, daß der Gewinn an Masse wenigstens 50 % beträgt.

4. Verfahren nach Anspruch 1, dadurch gekennzeichnet, daß die Breite der gehärteten Zonen wenigstens der Tiefe des zu bewirkenden chemischen Abtragens entspricht.

5. Verfahren nach Anspruch 4, dadurch gekennzeichnet, daß die Breite der gehärteten Zonen wenigstens·den 1,5-fachen der Tiefe des zu bewirkenden chemischen Abtragens entspricht.

6. Verfahren nach Anspruch 1, dadurch gekennzeichnet, daß die einheitliche Fläche der nicht gehärteten Zonen 0,25 cm$^2$ bis 1 cm$^2$ beträgt.

7. Erleichterte, durch das Verfahren gemäß Anspruch 1 hergestellte Solarzelle, deren Substrat verdünnte Zonen aufweist, deren Dicke gleichförmig auf Werte zwischen 10 $\mu$m und 100 $\mu$m reduziert ist, wobei die verdünnten Zonen voneinander durch Rippen des Substrats getrennt sind.

FIG.:1

FIG.:2

FIG.:3

FIG.:4

FIG.:5

FIG.:6A

FIG.:6 B